(19) Europäisches Patentamt

European Patent Office

Office européen des brevets

(11) **EP 3 379 332 A1**

(12) **EUROPEAN PATENT APPLICATION**

(43) Date of publication:
**26.09.2018 Bulletin 2018/39**

(51) Int Cl.:
***G03F 1/62*** (2012.01)   ***G03F 7/20*** (2006.01)

(21) Application number: **17162725.0**

(22) Date of filing: **24.03.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ASML Netherlands B.V.
5500 AH Veldhoven (NL)**

(72) Inventors:
• **VAN KESSEL, Marcel, Theodorus, Maria
5500 AH Veldhoven (NL)**

• **DE JONG, Frederik Eduard
5500 AH Veldhoven (NL)**
• **BROUWER, Cornelis, Melchior
5500 AH Veldhoven (NL)**
• **VAN DE RUIT, Kevin
5500 AH Veldhoven (NL)**
• **LI, Chung-Hsun
5500 AH Veldhoven (NL)**

(74) Representative: **Peters, John Antoine
ASML Netherlands BV
Corporate Intellectual Property
P.O. Box 324
5500 AH Veldhoven (NL)**

(54) **LITHOGRAPHIC APPARATUS BEING OPERABLE TO DETERMINE PELLICLE DEGRADATION COMPENSATION CORRECTIONS**

(57)    Disclosed is a method for mitigating an effect of non-uniform pellicle degradation on control of a substrate patterning process and an associated lithographic apparatus. The method comprises quantifying an effect of the non-uniform pellicle degradation on one or more properties of patterned features, such as metrology targets, formed on the substrate by the substrate patterning process. A process control correction is then determined based on the quantification of the effect of the non-uniform pellicle degradation.

Fig. 3

**Description**

FIELD

The present invention relates to methods usable, for example, in the manufacture of devices by lithographic techniques.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatuses include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti parallel to this direction. It is also possible to transfer the pattern from the patterning device to the substrate by imprinting the pattern onto the substrate.

A key performance parameter of any lithographic process, particularly one used for the manufacture of semiconductor devices, is the so-called overlay. Overlay is the accuracy (or the error) to which features in an applied pattern can be positioned directly on top of cooperating features applied to the same substrate in an earlier step. Modern lithographic processes may apply many measurements, modeling and correction steps to eliminate sources of error in the positioning of features, to achieve overlay of only a few nanometers. As the performance of lithographic apparatuses improves, reticle deformations, caused by for example clamping stresses, sagging, and reticle heating during exposures, are becoming a limiting factor for overlay improvements.

An issue with imaging performance of a lithographic apparatus is contamination of the reticle. Contaminants on the reticle can be imaged onto the substrate resulting in imaging errors and a consequent negative impact on yield. To prevent this, a membrane or pellicle may be used as a physical barrier across the reticle to prevent contaminants from falling on the reticle. Such a pellicle, and therefore any contaminants on the pellicle, will be located too far out of focus to be imaged on the substrate. The pellicle may comprise a thin transparent film stretched over a frame that is attached (e.g., glued) over one side of the reticle.

Pellicles may degrade over time due to irradiation by the exposure radiation, and particularly DUV radiation comprised with the exposure radiation. This optical degradation may be non-uniform over the pellicle. Such non-uniform degradation can affect the transmissive properties of the pellicle resulting in aberrations which can cause a shift in a measured metrology target image location when, for example, imaging a metrology target through the pellicle.

SUMMARY

It would be desirable to mitigate for the effect of non-uniform optical degradation of the pellicle.

The invention in a first aspect describes a method for mitigating an effect of non-uniform pellicle degradation on control of a substrate patterning process, the method comprising: quantifying an effect of the non-uniform pellicle degradation on one or more properties of patterned features formed on the substrate by said substrate patterning process; and determining a correction for control of the substrate patterning process based on the quantification of the effect of the non-uniform pellicle degradation.

The invention further provides lithographic apparatus comprising: a patterning device for imparting a pattern to a radiation beam in a substrate patterning process; a pellicle attached to the patterning device; a process control system for controlling the substrate patterning process, said process control system being operable to: quantify an effect of non-uniform pellicle degradation on one or more properties of patterned features formed on the substrate by said substrate patterning process; and determine a correction for the process control system based on the quantification of the effect of the non-uniform pellicle degradation.

The invention yet further provides a computer program product comprising machine-readable instructions for causing a processor to perform the method of the first aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus;
Figure 2 schematically shows a top down view of (a) a reticle at reticle level and (b) a pellicle at pellicle level illustrating the cumulative received dose at pellicle level; and
Figure 3 schematically shows a reticle and pellicle arrangement during exposure illustrating the effect of non-uniform pellicle degradation.

DETAILED DESCRIPTION OF EXEMPLARY EMBODIMENTS

Before describing embodiments of the invention in detail, it is instructive to present an example environment in which embodiments of the present invention may be implemented.

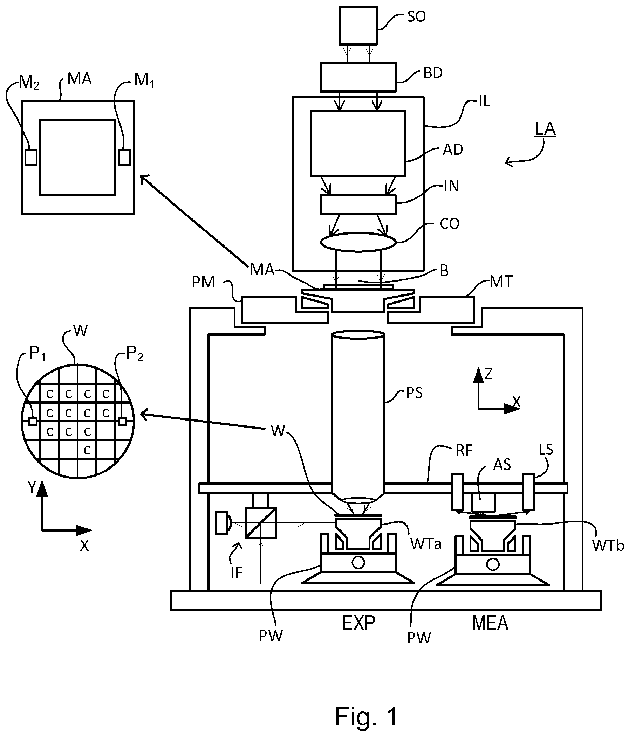

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a reticle or mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment marks on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

A patterning device (hereafter referred to as a reticle) typically has a pellicle mounted thereto to prevent contaminants on the reticle affecting the exposure. Upon DUV irradiation, a pellicle can optically degrade. It is known that this degradation has an impact on CD/CDU (critical dimension/CD uniformity), and for this reason the pellicle is typically replaced after exposure to a certain level of cumulative dose. However, replacement of the pellicle results in significant downtime and can only be done a certain number of times.

The inventors have now determined that there is an overlay impact due to this optical degradation, and the mechanism behind this. Currently there is no addressing or mitigation of the overlay impact due to a degraded pellicle.

The mechanism whereby optical degradation of a pellicle impacts overlay is as follows. Reticles may have a transmissive image field, comprising the product structures and a number of scribe lanes having metrology targets for process correction measurements, and a non-transmissive image border to shield neighboring fields during exposure. The pellicle beneath the image field will be irradiated with DUV and therefore degrade optically. Any uniform optical degradation impacts CD/CDU, but will not impact overlay. However, beneath the image border there will be a cumulative dose gradient area, beginning at a point where the maximum cumulative dose is received, and falling to a point were zero cumulative dose is received. This results in an optical degradation gradient at these regions of the pellicle. The size of this dose gradient area (and therefore optical degradation gradient area) will depend on the illumination setting used during exposure. This dose gradient area size may also depend on the presence and effect of local structures in scribe lanes or near the edge of image field because of diffraction.

The image border typically comprises scribe lanes and many metrology targets, as scribe lanes are a convenient place to locate such metrology targets. The effect of the optical degradation gradient area is that, when imaging (exposing) a metrology target near the image border, the optical degradation gradient causes aberrations, which in turn cause a shift (relative to an expected or nominal position) of the metrology target image location, and therefore the actual position of the imaged target on the substrate.

More specifically, the action of DUV radiation causes a change in thickness and/or refractive index of the pellicle material. At the image border area, where there is a cumulative dose gradient on the pellicle, the degradation over time results in the formation of a pellicle thickness / refractive index gradient at this border area. When imaging metrology targets within this image border area, with a certain illumination setting, the pellicle might induce an optical path length difference for different parts of the pupil, i.e. induce an aberration, causing a shift of the target. When two layers are formed with a different illumination setting and / or be subject to a different degradation state, this can cause an overlay penalty between the two layers.

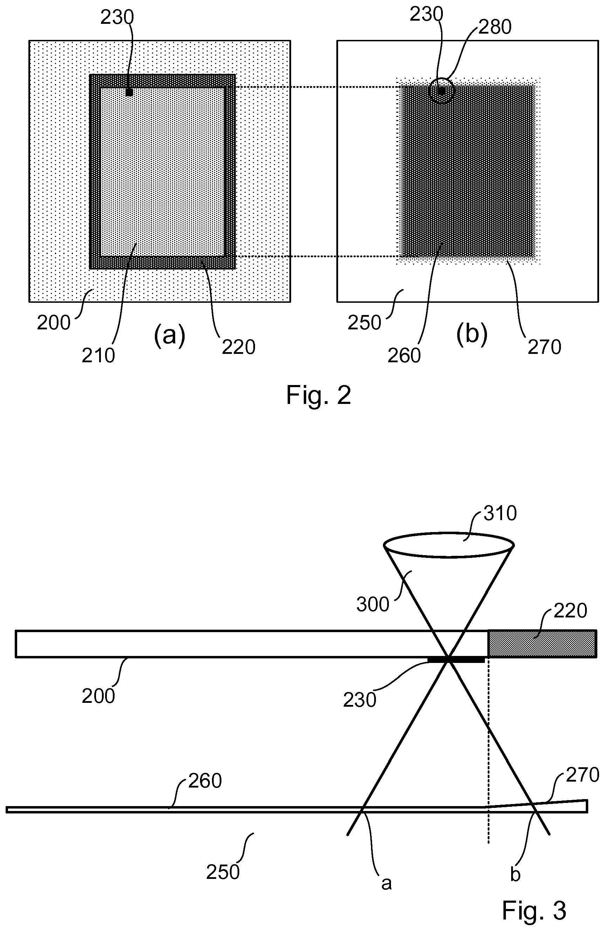

Figures 2 and 3 illustrate this effect. Figure 2(a) is a reticle level schematic drawing which shows the reticle 200. The reticle 200 has an image field 210 and an image border area 220. Also shown is a metrology target forming feature 230 on the image field 210 of reticle 200 and adjacent to the image border area 220. Figure 2(b) is a pellicle level schematic drawing illustrating the received dose on a pellicle 250, when imaging using the reticle 200. The shading 240 illustrates the dose received, with darker shading illustrating a greater received cumulative dose. As can be seen, a pellicle image field area 260 of pellicle 250, which broadly corresponds with image field 210, receives the greatest dose level. However this is substantially constant over the pellicle image field area 260. It can also be seen that a pellicle border area 270 of pellicle 250, which broadly corresponds with image border area 220, receives a dose gradient such that the received dose level reduces with distance away from the pellicle image field area 260. The length of this pellicle border area 270 will depend on illumination setting (and possibly nearby diffracting structures). Also shown for reference is the position of the metrology target forming feature 230 (on the reticle 200), and a circle 280 which represents the area of the pellicle through which the radiation beam patterned by the metrology target forming feature 230 passes. Therefore, this area 280 of the pellicle 250 will affect the imaging quality of the exposed target on the substrate. As this area 280 includes part of the pellicle border area 270, the effect of the dose gradient on the pellicle at this area will have an impact on the exposed target.

Figure 3 shows metrology target forming feature 230 near an image border area 220 being exposed by exposure radiation 300 (via projection optics 310). It shows a reticle 200 comprising metrology target forming feature 230, being exposed. Below the reticle 200, typically separated by a distance of a few millimeters (e.g., 5mm) is the pellicle 250. The exposure radiation 300 focused on the metrology target forming feature 230 will disperse to form an illumination cone, incident as an illumination spot of finite diameter on the pellicle 250. Due to the image border area 220 of the reticle, the pellicle border area 270 will receive a (cumulative) dose gradient, and therefore a degradation gradient (here shown as a thickness gradient). Considering two points a and b on the pellicle 250; due to the pellicle degradation gradient, the pellicle 250 at these points may have different refractive indices (respectively $n_1$ and $n_2$) with a refractive index gradient (at least partially) therebetween. The area between points a and b may correspond to the area 280 of Figure 2. It has been observed that a typical target sensitivity to pellicle aberration is 1nm shift per 1nm aberration, and that the magnitude of the aberration due to the effect disclosed herein is $d(n_1-n_2)$, where d is the pellicle thickness (which may be 300nm for example). As such, a refractive index gradient $(n_1-n_2)$ of about 1/300 will result in a 1nm target shift of the imaged target on the substrate.

After being imaged on the substrate, the metrology targets are typically measured as part of a process control loop, and exposure corrections are determined which minimize measured parameter value deviations (e.g., overlay errors/offsets) relative to a nominal or planned value for the measured parameter. The corrections can then be applied during subsequent exposures in a feedback loop. Such corrections may comprise, for example, control/positioning corrections of the substrate relative to the projection optics. When measuring the metrology marks affected by non-uniform pellicle degradation as part of such a process control loop, these shifts will be included in the determined correction. However, it should be clear that the aberrations due to optical degradation are purely an image field edge effect (border effect), not representing any real (global) distortion of the product area (where there are no such aberrations). Therefore, the correction (typically described and/or applied via global shapes) applied via the process control loop, will erroneously apply (add) the measured metrology target shifts over the whole product. This is the aforementioned overlay impact of non-uniform optical pellicle degradation.

A number of solutions are now proposed to reduce this (on-product) overlay impact due to non-uniform pellicle degradation, thereby improving total overlay performance.

A first solution comprises modelling the metrology target shifts, and then determining a correction for the estimated shift, per target. The expected metrology target shift can be determined (e.g., over time) from exposure context data such as: knowledge of the metrology target positions, the image field size, the illumination setting used and the cumulative dose. Once the metrology target shifts are determined, they can be used to calculate per-target corrections which compensate for these shifts.

The model inputs may, in part, be based on measurements of pellicle properties (e.g., measurement of refractive index gradient or thickness gradient). These measurements could be done inside the lithographic apparatus (e.g., scanner), or by some stand-alone tool. Alternatively, instead of actually measuring the pellicle properties (degradation gradient), this can be modeled. This modeling can be done based on *a priori* knowledge of the degradation effect on the pellicle, more specifically the sensitivity of pellicle optical degradation to the cumulative dose of radiation received.

The corrections can then be used to correct measurements of the metrology targets when they are measured as part of the process control loop for the lithographic (exposure) process, or else be combined with process control corrections based on measurements of the metrology targets. For example, the expected shift of the gratings in each of the two layers of an overlay metrology target, resultant from non-uniform pellicle degradation, can be determined. From this, the relative shift (corresponding to the overlay impact) between the two gratings can be calculated. This overlay shift will only have been applied to the image border, and will not be seen in the product area. Therefore it can be removed from overlay measurements of the target in the process control loop.

In a specific example, the modelling may comprise calculating, from a measured or modelled pellicle thickness variation d(x,y) over the pellicle, the aberration (optical path length difference ΔL with respect to nominal) per point within the exposure pupil according to:

$$\Delta L(\theta, \varphi) = n * (d(x,y) - d(x_c, y_c)) * \cos \theta \approx n * (d(x,y) - d(x_c, y_c)).$$

where: n is the refractive index of the pellicle, θ, φ are the angles relating to this pupil point, $(x_c, y_c)$ is the mark center and it is assumed that θ is small (cos θ = 1).

In an embodiment, such modelling may comprise a first order estimate. Higher order estimates may additionally be made using, for example, higher order (e.g., Zernike) models. From calculation of the aberration, the target shift can be estimated, as already described.

In an alternative embodiment, instead of modelling an estimated shift per metrology target as described, the shift can be measured (e.g., subsequent to exposure). Where the metrology target is an overlay target, it may be the shift of the individual gratings are measured individually, or else the overlay (relative shift between the two gratings) may be directly measured from a formed target (in the latter case, this overlay shift could be compared to measurement of a reference overlay target within the imaging area, which should not be subject to the non-uniform pellicle degradation effect). A further measurement alternative may comprise making aberration (e.g., Zernike) measurements directly using e.g., the alignment metrology system of the scanner. To do this, dedicated marks should be provided at the appropriate position on the reticle. The shift can then be determined from the measured aberration.

In a preferred embodiment, measurement of the shift (e.g., of individual gratings of a metrology target) is performed within the scanner using one of the scanner metrology systems (e.g., the alignment system). As the actual metrology targets used in process control are typically of a pitch which is too small to be detected by the scanner metrology systems, such an embodiment may comprise including dedicated targets (e.g., gratings) on the reticle which are readable by a scanner metrology system. These dedicated targets should be such that they undergo the same shift as the actual process control metrology targets, or else the metrology target shift can be calculated from measured shift of the dedicated targets. The measured shifts can then be used to calculate a (per-target) correction for the process control loop as described in the preceding embodiment.

In yet another embodiment, the mitigation may be done within the process control loop. Such an embodiment may comprise identifying or constructing one or more parameters which are substantially insensitive/invariant, or display a low sensitivity, to the effects of the non-uniform pellicle degradation (e.g., the target shift). Substantially invariant may be defined as being invariant within a threshold variance margin, for example. By knowing the target locations, it is proposed to predict how the imaging of these targets is going to be impacted by the non-uniform pellicle degradation. This can be done, for example, by estimating (modelling) or measuring the target shifts, as described. It can then be determined which one or more of the process control parameters will be impacted by this degradation. Some parameters might be sensitive to the target shifts and some not, depending on the symmetries of the parameter. Such an embodiment comprises only using parameters identified as substantially invariant (or least invariant) to the target shifts, for control of the lithographic process in a process control loop, ensuring that the mechanism causes no overlay impact. A tool may be used which calculates the degree to which each parameter is affected, and determines, based on this, whether that parameter should be used in the process control loop. In this way, the process control parameter choice criteria is related to the pellicle dose gradients and optical pellicle degradation.

In a specific implementation of this embodiment, parameters may be constructed that are insensitive to a particular pattern of target shifts as induced by pellicle degradation, based on knowledge of target locations. Such parameters may describe a geometrical effect orthogonal to the known fingerprint of pellicle degradation induced overlay displayed by the pattern of target shifts.

Further embodiments are given in the numbered embodiments below:

1. A method for mitigating an effect of non-uniform pellicle degradation on control of a substrate patterning process, the method comprising:

quantifying an effect of the non-uniform pellicle degradation on one or more properties of patterned features formed on the substrate by said substrate patterning process; and determining a correction for control of the substrate patterning process based on the quantification of the effect of the non-uniform pellicle degradation.

2. A method according to embodiment 1, wherein said one or more properties of patterned features formed on the substrate comprises a shift in imaged position of the patterned features relative to a nominal position.

3. A method according to embodiment 2, wherein said correction comprises a correction of a subsequent overlay measurement based on one or more of said patterned features.

4. A method according to embodiment 3, comprising determining a relative shift representative of an overlay error between a first layer and a second layer resultant from said non-uniform pellicle degradation, the relative shift being between:

a first shift in imaged position of a first patterned feature in a first layer of the substrate patterning process; and a second shift in imaged position of a second patterned feature in a second layer of the substrate patterning process; wherein said correction comprises a correction of a subsequent overlay measurement based on said first patterned feature and second patterned feature.

5. A method according to any preceding embodiment, wherein said each of said patterned features comprise a metrology target, or a grating forming part of a metrology target.

6. A method according to embodiment 5, wherein a correction is determined per metrology target and/or grating.

7. A method according to any preceding embodiment, comprising: modelling the effect of the non-uniform pellicle degradation on one or more properties of patterned features formed on the substrate; and determining said correction based on the modelled effect.

8. A method according to embodiment 7, comprising: performing a pellicle measurement of one or more pellicle properties quantifying the non-uniform pellicle degradation; and using said pellicle measurement in said modelling step.

9. A method according to embodiment 7, comprising modelling the non-uniform pellicle degradation and using the modelled non-uniform pellicle degradation in said step of modelling the effect of the non-uniform pellicle degradation.

10. A method according to any of embodiments 7 to 9 wherein said modelling is based on exposure context data relating to the substrate patterning process, said exposure context data comprising knowledge of one or more of: locations of the patterned features, dimensions of an image field of a patterning device used in the substrate patterning process, an illumination setting of projection optics used in the substrate patterning process and the cumulative dose imparted on the pellicle.

11. A method according to any of embodiments 1 to 6, comprising: measuring the effect of the non-uniform pellicle degradation on one or more properties of patterned features formed on the substrate; and determining said correction based on the measured effect.

12. A method according to embodiment 11, wherein said substrate patterning process is performed on a lithographic apparatus, and said method comprises: forming additional metrology targets measurable by the lithographic apparatus for measuring said effect of the non-uniform pellicle degradation; and performing said step of measuring the effect of the non-uniform pellicle degradation by measuring said additional metrology targets using said lithographic apparatus.

13. A method according to any preceding embodiment, wherein the step of determining said correction comprises: identifying one or more invariant parameters which are substantially invariant to said effect of the non-uniform pellicle degradation; and determining said correction only in terms of said invariant parameters.

14. A method according to any of embodiments 1 to 12, wherein the step of determining said correction comprises: determining a global fingerprint of said effect of the non-uniform pellicle degradation across the substrate; using said global fingerprint to construct one or more invariant parameters which describes a geometrical effect orthogonal to the said global fingerprint and is therefore substantially invariant to said effect of the non-uniform pellicle degradation; and determining said correction only in terms of said one or more invariant parameters.

15. A method according to any preceding embodiment, wherein said effect of the non-uniform pellicle degradation relates only to a non-product area of a patterning device used to perform said substrate patterning process, said non-product area not comprising product features to be imaged on said substrate, and at least a subset of the substrate patterning features are located within said non-product area.

16. A method according to embodiment 15, wherein said non-product area comprises an image border area at the periphery of a main imaging area comprising said product features.

17. A lithographic apparatus comprising: a patterning device for imparting a pattern to a radiation beam in a substrate patterning process; a pellicle attached to the patterning device; a process control system for controlling the substrate patterning process, said process control system being operable to: quantify an effect of non-uniform pellicle degradation on one or more properties of patterned features formed on the substrate by said substrate patterning process; and determine a correction for the process control system based on the quantification of the effect of the non-uniform pellicle degradation.

18. A lithographic apparatus according to embodiment 17, wherein said one or more properties of patterned features formed on the substrate comprises a shift in imaged position of the patterned features relative to a nominal position.

19. A lithographic apparatus according to embodiment 18, operable such that said correction comprises a correction of a subsequent overlay measurement based on one or more of said patterned features.

20. A lithographic apparatus according to embodiment 19, comprising wherein said process control system is further operable to: determine a first shift in imaged position of a first patterned feature in a first layer of the substrate patterning process and a second shift in imaged position of a second patterned feature in a second layer of the substrate patterning process; determine a relative shift between said first shift and said second shift, representative of an overlay error between the first layer and second layer resultant from said non-uniform pellicle degradation; wherein said correction comprises a correction of a subsequent overlay measurement based on said first patterned feature and second patterned feature.

21. A lithographic apparatus according to any of embodiments 17 to 20, being operable to form each of said patterned features, wherein each patterned feature comprises a metrology target, or a grating forming part of a metrology target.

22. A lithographic apparatus according to embodiment 21, wherein said process control system is operable to determine a correction per metrology target and/or grating.

23. A lithographic apparatus according to any of embodiments 17 to 22, wherein said process control system is operable to: model the effect of the non-uniform pellicle degradation on one or more properties of patterned features formed on the substrate; and determine said correction based on the modelled effect.

24. A lithographic apparatus according to embodiment 23, wherein said process control system is operable to model said effect of the non-uniform pellicle degradation based on exposure context data relating to the substrate patterning process, said exposure context data comprising knowledge of one or more of: locations of the patterned features, dimensions of an image field of the patterning device, an illumination setting of the lithographic apparatus and the cumulative dose imparted on the pellicle.

25. A lithographic apparatus according to embodiment 23 or 24, wherein said process control system is operable to perform said modelling based on a pellicle measurement of one or more pellicle properties quantifying the non-uniform pellicle degradation.

26. A lithographic apparatus according to embodiment 25, being operable to perform said pellicle measurement.

27. A lithographic apparatus according to embodiment 23 or 24, wherein said process control system is operable to: model the non-uniform pellicle degradation on one or more properties of patterned features formed on the substrate; and use the modelled non-uniform pellicle degradation in said step of modelling the effect of the non-uniform pellicle degradation.

28. A lithographic apparatus according to any of embodiments 1 to 22, wherein said process control system is operable to determine said correction based on a measurement of the effect of the non-uniform pellicle degradation on one or more properties of patterned features formed on the substrate.

29. A lithographic apparatus according to embodiment 28, being operable to perform said measurement of the effect of the non-uniform pellicle degradation on one or more properties of patterned features.

30. A lithographic apparatus according to embodiment 29, comprising an alignment system for positioning of the substrate, said alignment system being operable to perform said measurement of the effect of the non-uniform pellicle degradation on one or more properties of patterned features.

31. A lithographic apparatus according to embodiment 29 or 30, being operable to: form additional metrology targets measurable by the lithographic apparatus; and perform said measurement of the effect of the non-uniform pellicle degradation by measuring said additional metrology targets.

32. A lithographic apparatus according to any of embodiments 17 to 31, wherein said process control system is operable to determine said correction by being operable to: identify one or more invariant parameters which are substantially invariant to said effect of the non-uniform pellicle degradation; and determine said correction only in terms of said invariant parameters.

33. A lithographic apparatus according to any of embodiments any of embodiments 17 to 31, wherein said process control system is operable to determine said correction by being operable to: determine a global fingerprint of said effect of the non-uniform pellicle degradation across the substrate; use said global fingerprint to construct one or more invariant parameters which describes a geometrical effect orthogonal to the said global fingerprint and is therefore substantially invariant to said effect of the non-uniform pellicle degradation; and determine said correction only in terms of said one or more invariant parameters.

34. A lithographic apparatus according to any of embodiments 17 to 33, wherein said effect of the non-uniform pellicle degradation relates only to a non-product area of the patterning device, said non-product area not comprising product features to be imaged on said substrate, and at least a subset of the substrate patterning features are located within said non-product area.

35. A lithographic apparatus according to embodiment 34, wherein said non-product area comprises an image border area at the periphery of a main imaging area comprising said product features.

36. A lithographic apparatus according to any of embodiments 17 to 35; being further operable to use said correction when performing said substrate patterning process to a series of subsequent substrates.

37. A computer program comprising processor readable instructions which, when run on suitable processor controlled apparatus, cause the processor controlled apparatus to perform the method of any one of embodiments 1 to 16.

38. A computer program carrier comprising the computer program of embodiment 37.

39. A method of manufacturing devices wherein a device pattern is applied to a series of substrates using a substrate patterning process, the method including: using the method of any of embodiments 1 to 16 to determine a correction for mitigating an effect of non-uniform pellicle degradation on a process control system, and controlling the substrate patterning process using the determined corrections.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultraviolet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

**Claims**

1.  A lithographic apparatus comprising:

   a patterning device for imparting a pattern to a radiation beam in a substrate patterning process;

a pellicle attached to the patterning device;

a process control system for controlling the substrate patterning process, said process control system being operable to:

quantify an effect of non-uniform pellicle degradation on one or more properties of patterned features formed on the substrate by said substrate patterning process; and

determine a correction for the process control system based on the quantification of the effect of the non-uniform pellicle degradation.

2. A lithographic apparatus as claimed in claim 1, wherein said one or more properties of patterned features formed on the substrate comprises a shift in imaged position of the patterned features relative to a nominal position.

3. A lithographic apparatus as claimed in claim 2, operable such that said correction comprises a correction of a subsequent overlay measurement based on one or more of said patterned features.

4. A lithographic apparatus as claimed in any of claims 1 to 3, wherein said process control system is operable to:

model the effect of the non-uniform pellicle degradation on one or more properties of patterned features formed on the substrate; and

determine said correction based on the modelled effect.

5. A lithographic apparatus as claimed in claim 4, wherein said process control system is operable to model said effect of the non-uniform pellicle degradation based on exposure context data relating to the substrate patterning process, said exposure context data comprising knowledge of one or more of: locations of the patterned features, dimensions of an image field of the patterning device, an illumination setting of the lithographic apparatus and the cumulative dose imparted on the pellicle.

6. A lithographic apparatus as claimed in claim 4 or 5, wherein said process control system is operable to perform said modelling based on a pellicle measurement of one or more pellicle properties quantifying the non-uniform pellicle degradation.

7. A lithographic apparatus as claimed in claim 6, being operable to perform said pellicle measurement.

8. A lithographic apparatus as claimed in claim 6 or 7, wherein said process control system is operable to:

model the non-uniform pellicle degradation on one or more properties of patterned features formed on the substrate; and

use the modelled non-uniform pellicle degradation in said step of modelling the effect of the non-uniform pellicle degradation.

9. A lithographic apparatus as claimed in any of claims 1 to 3, wherein said process control system is operable to determine said correction based on a measurement of the effect of the non-uniform pellicle degradation on one or more properties of patterned features formed on the substrate.

10. A lithographic apparatus as claimed in claim 9, being operable to perform said measurement of the effect of the non-uniform pellicle degradation on one or more properties of patterned features.

11. A lithographic apparatus as claimed in claim 10, comprising an alignment system for positioning of the substrate, said alignment system being operable to perform said measurement of the effect of the non-uniform pellicle degradation on one or more properties of patterned features.

12. A lithographic apparatus as claimed in claim 10 or 11, being operable to:

form additional metrology targets measurable by the lithographic apparatus; and

perform said measurement of the effect of the non-uniform pellicle degradation by measuring said additional metrology targets.

13. A lithographic apparatus as claimed in any of claims 1 to 12, wherein said process control system is operable to determine said correction by being operable to:

identify one or more invariant parameters which are substantially invariant to said effect of the non-uniform pellicle degradation; and
determine said correction only in terms of said invariant parameters.

14. A lithographic apparatus as claimed in any of claims any of claims 1 to 13, wherein said process control system is operable to determine said correction by being operable to:

determine a global fingerprint of said effect of the non-uniform pellicle degradation across the substrate;
use said global fingerprint to construct one or more invariant parameters which describes a geometrical effect orthogonal to the said global fingerprint and is therefore substantially invariant to said effect of the non-uniform pellicle degradation; and
determine said correction only in terms of said one or more invariant parameters.

15. A lithographic apparatus as claimed in any of claims 1 to 14; being further operable to use said correction when performing said substrate patterning process to a series of subsequent substrates.

Fig. 1

Fig. 2

Fig. 3

Europäisches Patentamt

European Patent Office

Office européen des brevets

## EUROPEAN SEARCH REPORT

Application Number

EP 17 16 2725

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/009411 A1 (HIBBS MICHAEL STRAIGHT [US]) 15 January 2004 (2004-01-15)<br>* abstract *<br>* paragraphs [0001], [0004], [0005], [0016] - [0038]; claim 16; figures 1-10 * | 1-15 | INV.<br>G03F1/62<br>G03F7/20 |
| A | US 2009/027647 A1 (NAGAI YOSHIYUKI [JP] ET AL) 29 January 2009 (2009-01-29)<br>* abstract *<br>* paragraphs [0030], [0031], [0040] - [0047], [0060] - [0067]; figures 1,3, 4, 5,7 * | 1-15 | |

TECHNICAL FIELDS SEARCHED (IPC)

G03F

The present search report has been drawn up for all claims

| Place of search | Date of completion of the search | Examiner |
|---|---|---|
| Munich | 28 August 2017 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 16 2725

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2017

| Patent document cited in search report | | Publication date | Patent family member(s) | | Publication date |
|---|---|---|---|---|---|
| US 2004009411 | A1 | 15-01-2004 | JP | 3963377 B2 | 22-08-2007 |
| | | | JP | 2004046177 A | 12-02-2004 |
| | | | US | 2004009411 A1 | 15-01-2004 |
| | | | US | 2005069785 A1 | 31-03-2005 |
| US 2009027647 | A1 | 29-01-2009 | JP | 2009032747 A | 12-02-2009 |
| | | | US | 2009027647 A1 | 29-01-2009 |

EPO FORM P0459

For more details about this annex : see Official Journal of the European Patent Office, No. 12/82